# EUROPEAN PATENT APPLICATION

(11) **EP 2 772 947 A1**
(43) Date of publication of application: **03.09.2014**
(21) Application number: 12843919.7
(22) Date of filing: 05.10.2012
(51) Int. Cl.: H01L 31/042

(54) **SOLAR CELL MODULE HAVING DOUBLE GLASS STRUCTURE**

(30) Priority: 27.10.2011 JP 2011236015
(71) Applicant: Sharp Kabushiki Kaisha, Osaka-shi, Osaka 545-8522 (JP)
(72) Inventor: UMEMOTO, Takeshi, Osaka 545-8522 (JP); OBINATA, Ryosuke, Osaka 545-8522 (JP); NISHIYAMA, Hiroshi, Osaka 545-8522 (JP)
(74) Representative: Müller - Hoffmann & Partner
(86) International application number: PCT/JP2012/075935
(87) International publication number: WO 2013/061757

(57) **Abstract**

A solar cell module having a laminated glass structure includes: one glass substrate (100); a plurality of solar cells (110) provided on one glass substrate (100) and electrically interconnected; and a leader line provided on the plurality of solar cells (110) for extracting electric power generated by the plurality of solar cells (110). Furthermore, the solar cell module having the laminated glass structure includes: another glass substrate (170) opposite to one glass substrate (100) with the plurality of solar cells (110) and a portion of the leader line posed therebetween; and a resin sealant (160) sealing the plurality of solar cells (110) and the portion of the leader line between one glass substrate (100) and the other glass substrate (170). The leader line has the portion set in thickness to at most 30% relative to that of the resin sealant (161) located between the plurality of solar cells (110) and the other glass substrate (170).

## Description

### TECHNICAL FIELD

The present invention relates to a solar cell module having a laminated glass structure.

### BACKGROUND ART

A solar cell module having a laminated glass structure is configured as disclosed in a prior art document, Japanese Patent Laying-Open No. 2008-258269 (hereinafter referred to as Patent Document (PTD) 1). PTD 1 describes the solar cell module having the laminated glass structure including a glass substrate and a protection glass and applying a transparent resin or similar sealant therebetween to seal a plurality of solar cells, wiring, and the like therebetween.

### CITATION LIST

### PATENT DOCUMENT

PTD 1: Japanese Patent Laying-Open No. 2008-258269

### SUMMARY OF INVENTION

### TECHNICAL PROBLEM

There is a demand that the solar cell module having the laminated glass structure as described in PTD 1 and the like be formed of a smaller number of members and have a thin profile for reduced cost.

The present invention has been made to address the above issue and contemplates a solar cell module having a laminated glass structure that is inexpensive and has a thin profile.

### SOLUTION TO PROBLEM

The present invention provides a solar cell module having a laminated glass structure, including: a first glass substrate; a plurality of solar cells provided on the first glass substrate and electrically interconnected; and a leader line provided on the plurality of solar cells for extracting electric power generated by the plurality of solar cells. Furthermore, the solar cell module having the laminated glass structure includes: a second glass substrate opposite to the first glass substrate with the plurality of solar cells and a portion of the leader line posed therebetween; and a resin sealant sealing the plurality of solar cells and the portion of the leader line located between the first glass substrate and the second glass substrate. The leader line has the portion set in thickness to at most 30% relative to that of the resin sealant located between the plurality of solar cells and the second glass substrate.

Preferably, the resin sealant located between the plurality of solar cells and the second glass substrate is at most 400 µm in thickness.

In one embodiment of the present invention, the resin sealant is thermally set at 100-200 degrees centigrade.

In one embodiment of the present invention, the resin sealant includes ionomer resin.

### ADVANTAGEOUS EFFECT OF INVENTION

The present invention can thus provide a solar cell module having a laminated glass structure that is reduced in thickness.

### BRIEF DESCRIPTION OF DRAWINGS

Fig. 1 is an exploded perspective view of a portion in configuration of a solar cell module having a laminated glass structure according to an embodiment of the present invention.
Fig. 2 is a partial cross section of a solar cell shown in Fig. 1, as taken and seen along an arrow II-II shown in Fig 1.
Fig. 3 is a perspective view of the solar cell with a leader line thereon.
Fig. 4 is an exploded perspective view in configuration of the solar cell module having the laminated glass structure according to the present embodiment.
Fig. 5 is a cross section of the solar cell module having the laminated glass structure according to the present embodiment, as seen in the same direction as Fig. 2.
Fig. 6 dimensionally shows in cross section as a comparative example 1 a solar cell module having a laminated glass structure that is not of thin profile with a resin sealant heated to 125 degrees centigrade and thus fused.
Fig. 7 dimensionally shows in cross section comparative example 1 with the resin sealant thermally set and subsequently cooled to 25 degrees centigrade and having shrunk freely.
Fig. 8 dimensionally shows in cross section comparative example 1 with the resin sealant thermally set and subsequently cooled to 25 degrees centigrade and having shrunk.
Fig. 9 dimensionally shows in cross section as a comparative example 2 a solar cell module having a laminated glass structure with a resin sealant reduced in thickness, and heated to 125 degrees centigrade and thus fused.
Fig. 10 dimensionally shows in cross section comparative example 2 with the resin sealant thermally set and subsequently cooled to 25 degrees centigrade and having shrunk freely.
Fig. 11 dimensionally shows in cross section comparative example 2 with the resin sealant thermally set and subsequently cooled to 25 degrees centigrade and having shrunk.
Fig. 12 dimensionally shows in cross section the present embodiment that is a solar cell module having a laminated glass structure with a resin sealant reduced in thickness, and heated to 125 degrees centigrade and thus fused.
Fig. 13 dimensionally shows in cross section the present embodiment with the resin sealant thermally set and subsequently cooled to 25 degrees centigrade and having shrunk freely.
Fig. 14 dimensionally shows in cross section the present embodiment with the resin sealant thermally set and subsequently cooled to 25 degrees centigrade and having shrunk.

### DESCRIPTION OF EMBODIMENTS

The present invention in one embodiment provides a solar cell module having a laminated glass structure, as will be described hereinafter. In describing the following embodiment(s), components identically or correspondingly shown in the figures are identically denoted and will not be described repeatedly.

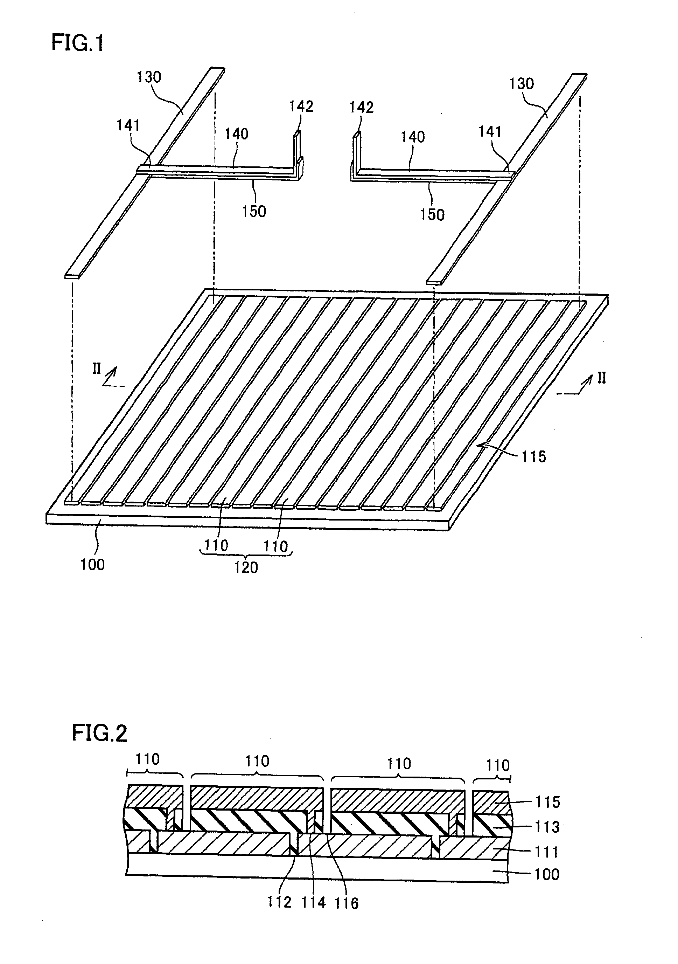

Fig. 1 is an exploded perspective view of a portion in configuration of a solar cell module having a laminated glass structure according to one embodiment of the present invention. Fig. 2 is a partial cross section of a solar cell shown in Fig. 1, as taken and seen along an arrow II-II shown in Fig 1.

As shown in Fig. 1, a first glass substrate or a glass substrate 100 bears a plurality of elongate solar cells 110 thereon in parallel.

As shown in Fig. 2, solar cell 110 includes glass substrate 100 located at a front surface (or a light receiving surface), a transparent electrode layer (an electrode layer adjacent to the front surface) 111 provided behind glass substrate 100, a photoelectric conversion layer 113 provided behind transparent electrode layer 111, and a back surface electrode layer 115 provided behind photoelectric conversion layer 113.

Transparent electrode layer 111, photoelectric conversion layer 113, and back surface electrode layer 115 are each patterned as prescribed. Transparent electrode layer 111, photoelectric conversion layer 113, and back surface electrode layer 115 are provided with a first separation line 112, a second separation line 114, and a third separation line 116,respectively, extending along solar cell 110.

First separation line 112 provided in transparent electrode layer 111 has photoelectric conversion layer 113 introduced therein. Second separation line 114 provided in photoelectric conversion layer 113 has back surface electrode layer 115 introduced therein.

Individual photoelectric conversion layers 113 divided by second separation line 114 are sandwiched between individual transparent electrode layers 111 divided by first separation line 112 and individual back surface electrode layers 115 divided by third separation line 116.

Back surface electrode layer 115 that is opposite to one transparent electrode layer 111 is connected to another transparent electrode layer 111 adjacent to the one transparent electrode layer 111 via a portion of back surface electrode layer 115 that is introduced in second separation line 114 dividing photoelectric conversion layer 113. Note that the portion of back surface electrode layer 115 is referred to as a contact line, in particular.

This allows individual photoelectric conversion layers 113 to be electrically interconnected via back surface electrode layer 115 and transparent electrode layer 111 and thus connects a plurality of solar cells 110 that are included in a solar cell string 120 in series.

Solar cell 110 is fabricated in a method, as will be described hereinafter. Thermal chemical vapor deposition (CVD) or the like is employed to deposit transparent electrode layer 111 on glass substrate 100. Transparent electrode layer 111 can for example be tin oxide (SnO₂) film, zinc oxide (ZnO) film, indium tin oxide (ITO) film, or the like.

Then, transparent electrode layer 111 is laser-scribed or the like and thus partially removed to form a plurality of first separation lines 112. This divides transparent electrode layer 111 into a plurality thereof. This can be done by using laser light that is a fundamental wave of yttrium aluminum garnet (YAG) laser (wavelength: 1064 nm) or the like for example.

Subsequently, plasma CVD or the like is employed to deposit photoelectric conversion layer 113 on transparent electrode layer 111. Photoelectric conversion layer 113 can be thin semiconductor film, and can for example be p, i and n layers formed of thin amorphous silicon film and successively stacked, one on another. This deposition allows first separation line 112 to have photoelectric conversion layer 113 introduced therein.

Then, photoelectric conversion layer 113 is laser-scribed or the like and thus partially removed to form a plurality of second separation lines 114. This divides photoelectric conversion layer 113 into a plurality thereof. This can be done by using laser light that is second harmonic of YAG laser (wavelength: 532 nm) or the like for example.

Subsequently, magnetron sputtering, electron-beam vapor deposition or the like is employed to deposit back surface electrode layer 115 on photoelectric conversion layer 113. Back surface electrode layers 115 can for example be zinc oxide (ZnO) film/silver (Ag) film, ZnO film/aluminum (Al) film, ITO film/Ag film, SnO₂ film/Ag film, or similar films stacked in layers. This deposition allows second separation line 114 to have back surface electrode layer 115 introduced therein and thus forms the contact line as described above.

Then, back surface electrode layer 115 is laser-scribed or the like and thus partially removed to form a plurality of third separation lines 116. This divides back surface electrode layer 115 into a plurality thereof. This can be done by using laser light that is second harmonic of YAG laser (wavelength: 532 nm) or the like for example.

Solar cell string 120 thus formed has opposite ends, i.e., solar cell 110 located at an end portion in a direction in which the plurality of solar cells 110 are aligned, to serve as a region to extract electric power from solar cell string 120.

Hereinafter, a leader line will be described that extracts generated electric power from the plurality of solar cells 110. As shown in Fig. 1, solar cell string 120 has the opposite ends with their solar cells 110 opposite to bus bars 130, respectively. Bus bar 130 is an elongate plate of metallic foil. Bus bar 130 has a generally center portion, as seen along bus bar 130, connected to a lead wire 140 at one end thereof serving as a connection portion 141.

Lead wire 140 extends in a direction transverse to bus bar 130. Lead wire 140 is an elongate plate of metallic foil. Lead wire 140 has the other end provided with a terminal portion 142 bent to be orthogonal to a direction in which lead wire 140 extends. Lead wire 140 at a side thereof excluding its opposite ends and facing solar cell 110 is covered with an insulating film 150.

Bus bar 130 and lead wire 140 configure a leader line for extracting electric power generated by the plurality of solar cells 110. Bus bar 130 and lead wire 140 are previously connected together via solder or the like before bus bar 130 is connected to solar cell 110.

When solar cell string 120 has one end to serve as a positive side, it has the other end to serve as a negative side. As such, bus bar 130 and lead wire 140 are disposed at the positive and negative sides and thus configure a pair of leader lines.

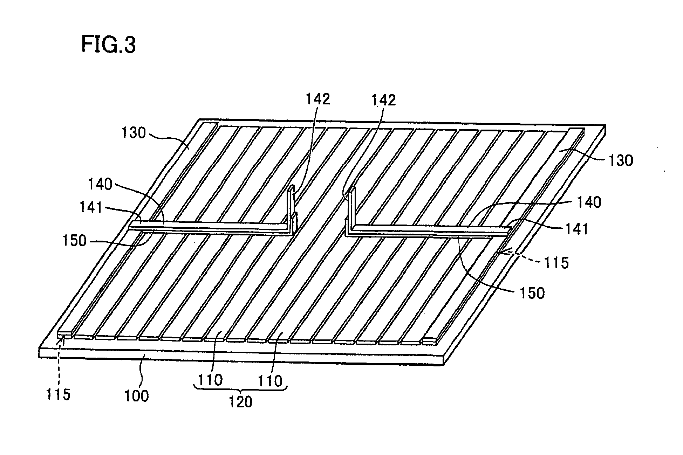

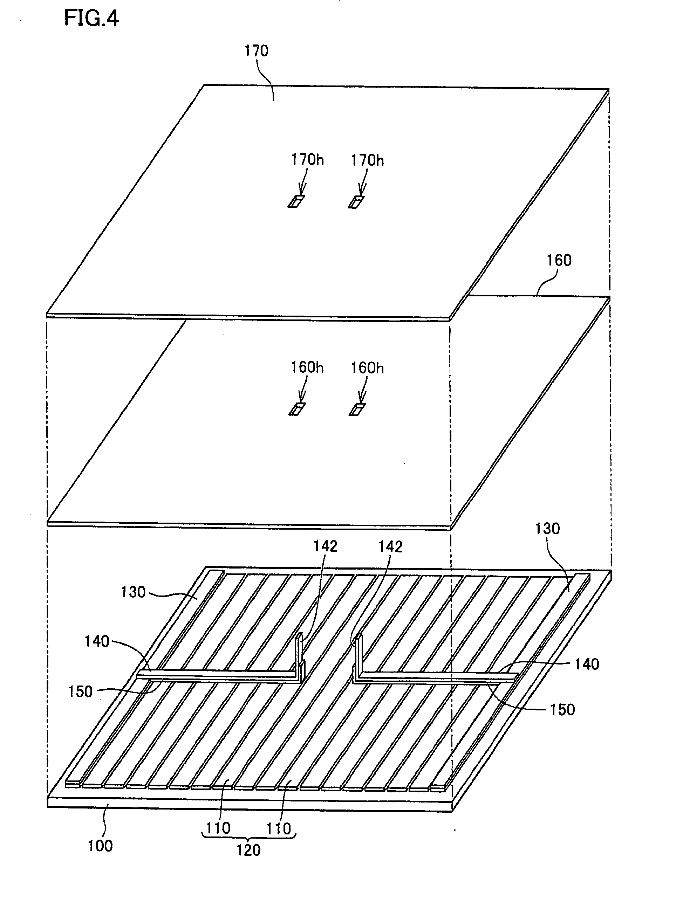

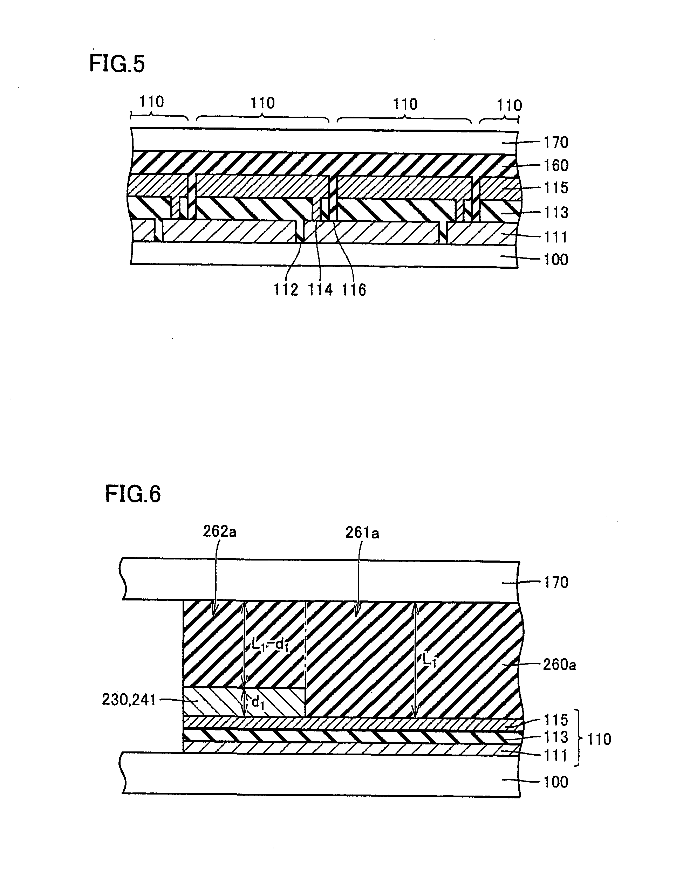

Fig. 3 is a perspective view of the solar cell with the leader line thereon. Fig. 4 is an exploded perspective view in configuration of the solar cell module having the laminated glass structure according to the present embodiment. Fig. 5 is a partial cross section of the solar cell module having the laminated glass structure according to the present embodiment, as seen in the same direction as Fig. 2.

As shown in Fig. 3, bus bar 130 is connected to back surface electrode layer 115 via a conductive paste previously applied to back surface electrode layer 115. As a result, solar cell string 120 has the positive and negative sides led to terminal portion 142 of the pair of leader lines.

As shown in Fig. 4, the solar cell module having the laminated glass structure includes a second glass substrate or glass substrate 170 cooperating with glass substrate 100 to sandwich the plurality of solar cells 110 and a portion of the leader line other than terminal portion 142. Glass substrate 170 has an opening 170h allowing the leader line to have terminal portion 142 passing therethrough.

Furthermore, the solar cell module having the laminated glass structure includes a resin sealant 160 sealing the plurality of solar cells 110 and the portion of the leader line other than terminal portion 142 between glass substrate 100 and glass substrate 170. Resin sealant 160 has an opening 160h allowing the leader line to have terminal portion 142 passing therethrough. Resin sealant 160 can for example be polyethylene terephthalate (PET) resin, ethylene vinyl acetate copolymer resin (EVA), ionomer resin, or the like.

After resin sealant 160 and glass substrate 170 are disposed, a vacuum lamination device is used to sandwich glass substrates 100 and 170 and thus externally apply pressure thereto and therewhile heat the intermediate product to fuse resin sealant 160, and thereafter it is set. Note that it is heated to 100-200 degrees centigrade. The solar cell module having the laminated glass structure is thus produced.

The solar cell module having the laminated glass structure thus produced has back surface electrode layer 115 covered with resin sealant 160 provided therebehind, as shown in Fig. 5. Third separation line 116 formed in back surface electrode layer 115 has resin sealant 160 introduced therein. Resin sealant 160 is covered with glass substrate 170 provided therebehind.

The leader line has terminal portion 142 extracted outside resin sealant 160 and glass substrate 170, and a terminal box (not shown) is attached to terminal portion 142 behind glass substrate 170.

The present inventors have found that when the solar cell module having the laminated glass structure produced as described above is reduced in thickness there is a possibility that solar cell 110 may have transparent electrode layer 111 and photoelectric conversion layer 113 peeled off from each other or photoelectric conversion layer 113 and back surface electrode layer 115 peeled off from each other.

Hereinafter will be described how solar cell 110 may have transparent electrode layer 111 and photoelectric conversion layer 113 peeled off from each other or photoelectric conversion layer 113 and back surface electrode layer 115 peeled off from each other, and a method for solving the same.

Fig. 6 dimensionally shows in cross section as a comparative example 1 a solar cell module having a laminated glass structure that is not of thin profile with a resin sealant heated to 125 degrees centigrade and thus fused. Note that Fig. 6 does not show first separation line 112, second separation line 114, or third separation line 116 for simplicity.

As shown in Fig. 6, in comparative example 1, a vacuum lamination device is employed to heat the resin sealant to 125 degrees centigrade and thus fuse the resin sealant, which is shown in the figure as resin sealant 260a, and resin sealant 260a has a portion between the plurality of solar cells 110 and glass substrate 170 which is shown in the figure as resin sealant 261a having a thickness L₁ for the sake of illustration. Furthermore, in comparative example 1, between glass substrate 100 and glass substrate 170 the leader line has a portion, i.e., bus bar 230 and the lead wire's connection portion 241, having a thickness d₁ for the sake of illustration.

Accordingly, in comparative example 1, the resin sealant heated by the vacuum lamination device to 125 degrees centigrade and thus fused, or resin sealant 260a, will have a portion between the leader line and glass substrate 170 which is shown in the figure as resin sealant 262a having a thickness L₁ - d₁.

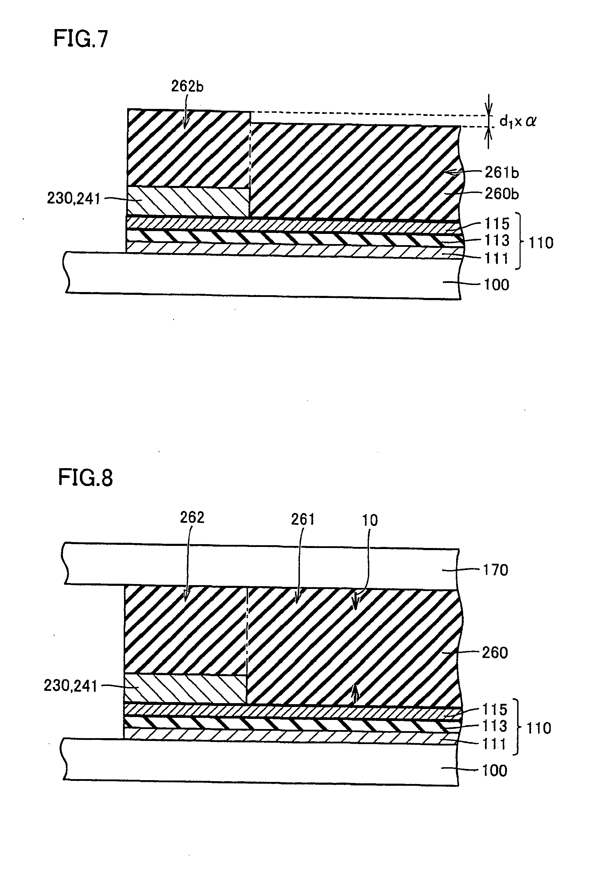

Resin sealant 260a fused is thermally set at 100-200 degrees centigrade. Fig. 7 dimensionally shows in cross section comparative example 1 with the resin sealant thermally set and subsequently cooled to 25 degrees centigrade and having shrunk freely. Herein, the resin sealant has a coefficient of linear expansion represented as α x 10⁻²/K for the sake of illustration.

When glass substrate 170 is not disposed, and the product is cooled by 100 degrees centigrade and resin sealant 260b thermally set shrinks, resin sealant 261b located between the plurality of solar cells 110 and glass substrate 170 will shrink in thickness in an amount L₁ x α. In contrast, resin sealant 262b located between the leader line and glass substrate 170 will shrink in thickness in an amount (L₁ - d₁) x α.

As shown in Fig. 7, resin sealant 261b and resin sealant 262b shrink in thickness in amounts, respectively, with a difference of d₁ x α. That is, the resin sealant shrinks in thickness in amounts with a difference in proportion to the leader line's thickness.

Fig. 8 dimensionally shows in cross section comparative example 1 with the resin sealant thermally set and subsequently cooled to 25 degrees centigrade and having shrunk. As shown in Fig. 8, resin sealant 260 that has been thermally set has been bonded to glass substrate 170 and accordingly, it cannot shrink freely when it is cooled to 25 degrees centigrade.

In other words, resin sealant 261 that is located between the plurality of solar cells 110 and glass substrate 170 and shrinks in a large amount can, in reality, only shrink in thickness to that of resin sealant 262 that is located between the leader line and glass substrate 170 and shrinks in a small amount.

This causes internal stress in resin sealant 261. By this internal stress, as indicated in Fig. 8 by an arrow 10, glass substrate 170 and solar cell 110 experience depthwise tensile stress.

Hereinafter will be described a solar cell module having a laminated glass structure of a comparative example 2 having the resin sealant reduced in thickness for thin profile.

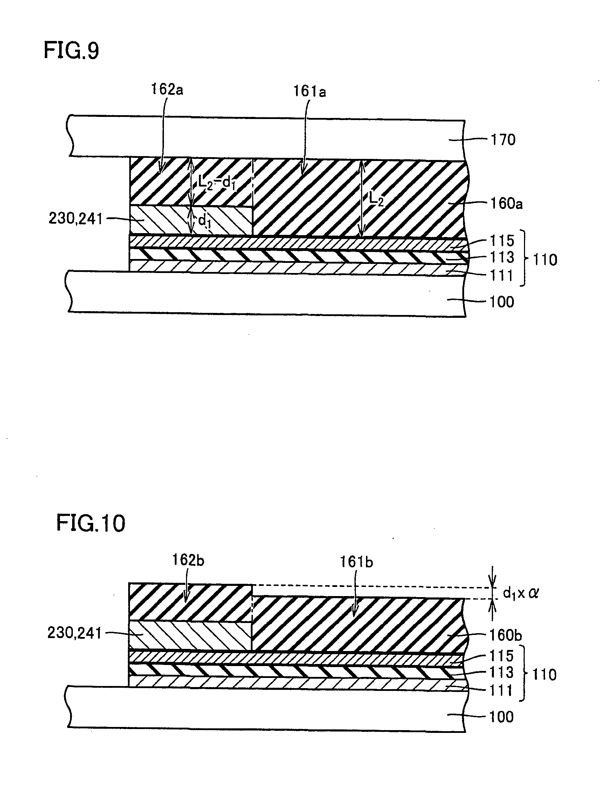

Fig. 9 dimensionally shows in cross section as comparative example 2 a solar cell module having a laminated glass structure with the resin sealant reduced in thickness, and heated to 125 degrees centigrade and thus fused. Note that Fig. 9 does not show first separation line 112, second separation line 114, or third separation line 116 for simplicity.

As shown in Fig. 9, in comparative example 2, the vacuum lamination device is employed to heat the resin sealant to 125 degrees centigrade and thus fuse the resin sealant, which is shown in the figure as resin sealant 160a, and resin sealant 160a has a portion between the plurality of solar cells 110 and glass substrate 170 which is shown in the figure as resin sealant 161a having a thickness L₂ for the sake of illustration. Note that L₁ > L₂. Furthermore, in comparative example 2, between glass substrate 100 and glass substrate 170 the leader line has a portion, i.e., bus bar 230 and the lead wire's connection portion 241, having thickness d₁ for the sake of illustration.

Accordingly, in comparative example 2, the resin sealant heated by the vacuum lamination device to 125 degrees centigrade and thus fused, or resin sealant 160a, will have a portion between the leader line and glass substrate 170 which is shown in the figure as resin sealant 162a having a thickness L₂ - d₁.

Fig. 10 dimensionally shows in cross section comparative example 2 with the resin sealant thermally set and subsequently cooled to 25 degrees centigrade and having shrunk freely.

When glass substrate 170 is not disposed, and the product is cooled by 100 degrees centigrade and resin sealant 160b thermally set shrinks, resin sealant 161b located between the plurality of solar cells 110 and glass substrate 170 will shrink in thickness in an amount L₂ x α. In contrast, resin sealant 162b located between the leader line and glass substrate 170 will shrink in thickness in an amount (L₂ - d₁) x α.

As shown in Fig. 10, resin sealant 161b and resin sealant 162b shrink in thickness in amounts, respectively, with a difference d₁ x α. That is, comparative example 2 also has the resin sealant shrinking in thickness in amounts with a difference in proportion to the leader line's thickness. Comparative example 2 has resin sealant 160 smaller in thickness than comparative example 1, and accordingly, a ratio of a difference between amounts by which the resin sealant shrinks to the resin sealant's thickness is larger in comparative example 2 than in comparative example 1.

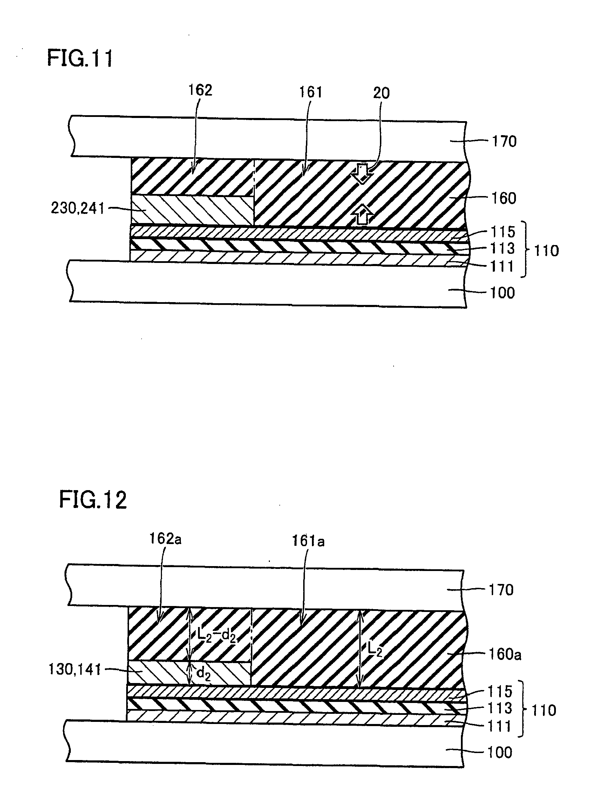

Fig. 11 dimensionally shows in cross section comparative example 2 with the resin sealant thermally set and subsequently cooled to 25 degrees centigrade and having shrunk. As shown in Fig. 11, resin sealant 160 that has been thermally set has been bonded to glass substrate 170 and accordingly, it cannot shrink freely when it is cooled to 25 degrees centigrade.

In other words, resin sealant 161 that is located between the plurality of solar cells 110 and glass substrate 170 and shrinks in a large amount can, in reality, only shrink in thickness to that of resin sealant 162 that is located between the leader line and glass substrate 170 and shrinks in a small amount.

As has been set forth above, comparative example 2 has a larger ratio of a difference between amounts by which the resin sealant shrinks to the resin sealant's thickness than comparative example 1, and accordingly, comparative example 2 has resin sealant 161 experiencing larger internal stress than comparative example 1. By this internal stress, as indicated in Fig. 11 by an arrow 20, comparative example 2 has glass substrate 170 and solar cell 110 experiencing larger depthwise tensile stress than comparative example 1.

In that case, solar cell 110 may have transparent electrode layer 111 and photoelectric conversion layer 113 peeled off from each other or back surface electrode layer 115 and photoelectric conversion layer 113 peeled off from each other.

Accordingly, in the present embodiment, the leader line is reduced in thickness to correspond to the resin sealant in thickness to alleviate internal stress caused in the resin sealant. Fig. 12 dimensionally shows in cross section the present embodiment that is a solar cell module having a laminated glass structure with a resin sealant reduced in thickness, and heated to 125 degrees centigrade and thus fused. Note that Fig. 12 does not show first separation line 112, second separation line 114, or third separation line 116 for simplicity.

As shown in Fig. 12, in the present embodiment, the vacuum lamination device is employed to heat the resin sealant to 125 degrees centigrade and thus fuse the resin sealant, which is shown in the figure as resin sealant 160a, and resin sealant 160a has a portion between the plurality of solar cells 110 and glass substrate 170 which is shown in the figure as resin sealant 161a having thickness L₂ for the sake of illustration. L₂ is 1.5 mm or smaller, for example. Furthermore, in the present embodiment, between glass substrate 100 and glass substrate 170 the leader line has a portion, i.e., bus bar 130 and the lead wire 140 connection portion 141, having a thickness d₂ for the sake of illustration. Note that d₁ > d₂.

Accordingly, in the present embodiment, the resin sealant heated by the vacuum lamination device to 125 degrees centigrade and thus fused, or resin sealant 160a, will have a portion between the leader line and glass substrate 170 which is shown in the figure as resin sealant 162a having a thickness L₂ - d₂.

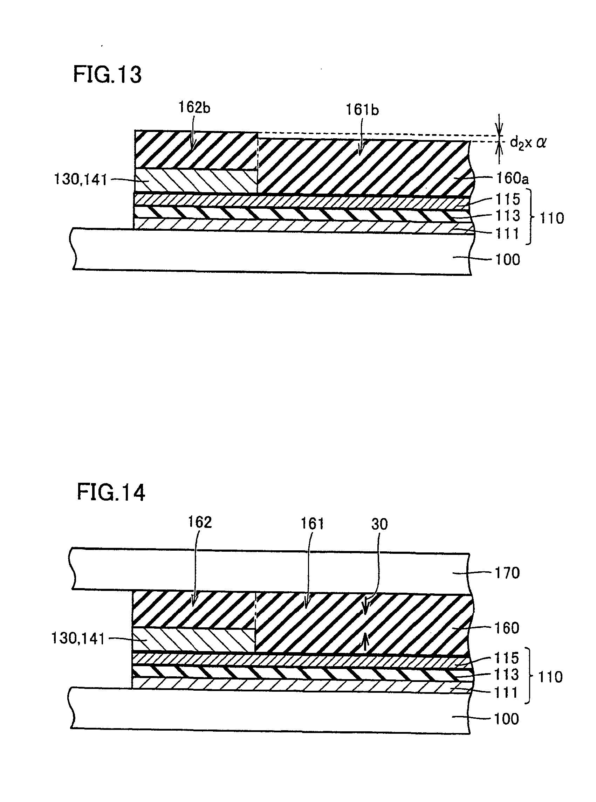

Fig. 13 dimensionally shows in cross section the present embodiment with the resin sealant thermally set and subsequently cooled to 25 degrees centigrade and having shrunk freely.

When glass substrate 170 is not disposed, and the product is cooled by 100 degrees centigrade and resin sealant 160b thermally set shrinks, resin sealant 161b located between the plurality of solar cells 110 and glass substrate 170 will shrink in thickness in an amount L₂ x α. In contrast, resin sealant 162b located between the leader line and glass substrate 170 will shrink in thickness in an amount (L₂ - d₂) x α.

As shown in Fig. 13, resin sealant 161b and resin sealant 162b shrink in thickness in amounts, respectively, with a difference d₂ x α. That is, the present embodiment also has the resin sealant shrinking in thickness in amounts with a difference in proportion to the leader line's thickness. The present embodiment has a leader line smaller in thickness than comparative example 2, and accordingly, the present embodiment has the resin sealant shrinking in thickness in amounts with a difference smaller than comparative example 2 does.

Fig. 14 dimensionally shows in cross section the present embodiment with the resin sealant thermally set and subsequently cooled to 25 degrees centigrade and having shrunk. As shown in Fig. 14, resin sealant 160 that has been thermally set has been bonded to glass substrate 170 and accordingly, it cannot shrink freely when it is cooled to 25 degrees centigrade.

In other words, resin sealant 161 that is located between the plurality of solar cells 110 and glass substrate 170 and shrinks in a large amount can, in reality, only shrink in thickness to that of resin sealant 162 that is located between the leader line and glass substrate 170 and shrinks in a small amount.

As has been set forth above, the present embodiment has the resin sealant shrinking in thickness in amounts with a difference smaller than comparative example 2, and accordingly, the present embodiment has resin sealant 161 experiencing smaller internal stress than comparative example 2. By this internal stress, as indicated in Fig. 14 by an arrow 30, the present embodiment has glass substrate 170 and solar cell 110 experiencing smaller depthwise tensile stress than comparative example 2.

Thus the leader line reduced in thickness to correspond to the resin sealant in thickness can contribute to alleviated internal stress caused in the resin sealant. This can minimize film peeling off in solar cell 110 in a solar cell module having a laminated glass structure of thin profile.

Hereinafter will be described an exemplary experiment conducted with the resin sealant and the leader line varied in thickness to examine whether solar cell 110 has peeling off therein.

### Exemplary Experiment

Resin sealant 160 of HIMILAN^{®} containing ionomer resin was used to fabricate a solar cell module having a laminated glass structure similar in configuration to the solar cell module having the laminated glass structure according to the present embodiment.

While a solar cell module having a laminated glass structure of thin profile is typically fabricated with resin sealant 160 having a thickness of 1.5 mm or smaller, the exemplary experiment was conducted with resin sealant 160 reduced in thickness to 400 µm or smaller. Resin sealant 160 reduced in thickness to 400 µm or smaller allows the solar cell module to have an end face allowing resin sealant 160 to have only a limited area externally exposed and can thus minimize external moisture or the like entering the solar cell module and hence enhance the solar cell module in weatherability.

Resin sealant 160 heated by the vacuum lamination device to 125 degrees centigrade and thus fused has a portion between the plurality of solar cells 110 and glass substrate 170, i.e., resin sealant 161, having a thickness L₃ for the sake of illustration. Furthermore, between glass substrate 100 and glass substrate 170 the leader line has a portion, i.e., bus bar 130 and the lead wire 140 connection portion 141, having a thickness d₃ for the sake of illustration.

In a comparative example, L₃ = 300 µm, d₃ = 120 µm, and (d₃/L₃) x 100 = 40%. In an example 1, L₃ = 300 µm, d₃ = 52 µm, and (d₃/L₃) x 100 = 17%. In an example 2, L₃ = 400 µm, d₃ = 120 µm, and (d₃/L₃) x 100 = 30%.

Whether solar cell 110 had peeling off therein was examined, and the comparative example has been found to have peeling off along bus bar 130, whereas examples 1 and 2 had no peeling off found.

Thus the solar cell module having the laminated glass structure of thin profile having a plurality of solar cells 110 and glass substrate 170 with resin sealant 161 of 400 µm or smaller in thickness therebetween, with a leader line having a portion (i.e., bus bar 130 and the lead wire 140 connection portion 141) set in thickness to 30% or smaller relative to that of resin sealant 161 located between the plurality of solar cells 110 and glass substrate 170, can alleviate internal stress caused in resin sealant 161 and minimize film peeling off in solar cell 110.

As a result, a solar cell module having a laminated glass structure that has a thin profile and can also minimize an increasing defect rate, and is significantly transparent, can be constantly produced.

Note, however, that if the leader line is excessively reduced in thickness the leader line is increased in electric resistance and reduced in strength and its members are inefficiently produced or the like, and accordingly, the leader line preferably has a portion (i.e., bus bar 130 and the lead wire 140 connection portion 141) set in thickness to 17% or larger relative to that of resin sealant 161 located between the plurality of solar cells 110 and glass substrate 170.

It should be understood that the embodiments disclosed herein have been described for the purpose of illustration only and in a non-restrictive manner in any respect. The scope of the present invention is defined by the terms of the claims, rather than the description above, and is intended to include any modifications within the meaning and scope equivalent to the terms of the claims.

### REFERENCE SIGNS LIST

100, 170: glass substrate; 110: solar cell; 111: transparent electrode layer; 112: first separation line; 113: photoelectric conversion layer; 114: second separation line; 115: back surface electrode layer; 116: third separation line; 120: solar cell string; 130, 230: bus bar; 140, 241: lead wire; 141: connection portion; 142: terminal portion; 150: insulating film; 160, 160a, 160b, 161, 161a, 161b, 162, 162a, 162b, 260, 260a, 260b, 261, 261a, 261b, 262, 262a, 262b: resin sealant; 160h, 170h: opening.

## Claims

1. A solar cell module having a laminated glass structure, comprising:
a first glass substrate (100);
a plurality of solar cells (110) provided on said first glass substrate (100) and electrically interconnected;
a leader line provided on said plurality of solar cells (110) for extracting electric power generated by said plurality of solar cells (110);
a second glass substrate (170) opposite to said first glass substrate (100) with said plurality of solar cells (110) and a portion of said leader line posed therebetween; and
a resin sealant (160) sealing said plurality of solar cells (110) and said portion of said leader line located between said first glass substrate (100) and said second glass substrate (170), said leader line having said portion set in thickness to at most 30% relative to that of said resin sealant (161) located between said plurality of solar cells (110) and said second glass substrate (170).

2. The solar cell module having the laminated glass structure according to claim 1, wherein said resin sealant (161) located between said plurality of solar cells (110) and said second glass substrate (170) is at most 400 µm in thickness.

3. The solar cell module having the laminated glass structure according to claim 1 or 2, wherein said resin sealant (160) is thermally set at 100-200 degrees centigrade.

4. The solar cell module having the laminated glass structure according to claim 3, wherein said resin sealant (160) includes ionomer resin.
